(19) Europäisches Patentamt
European Patent Office
Office européen des brevets

(11) EP 2 677 325 A2

(12) EUROPEAN PATENT APPLICATION

(43) Date of publication:
25.12.2013 Bulletin 2013/52

(51) Int Cl.:
*G01R 23/00* (2006.01)

(21) Application number: 13172568.1

(22) Date of filing: 18.06.2013

(84) Designated Contracting States:
AL AT BE BG CH CY CZ DE DK EE ES FI FR GB
GR HR HU IE IS IT LI LT LU LV MC MK MT NL NO
PL PT RO RS SE SI SK SM TR
Designated Extension States:
BA ME

(30) Priority: 20.06.2012 JP 2012138887

(71) Applicant: Yokogawa Electric Corporation
Tokyo 180-8750 (JP)

(72) Inventor: Sasaki, Shinichi
Tokyo 180-8750 (JP)

(74) Representative: Henkel, Breuer & Partner
Patentanwälte
Maximiliansplatz 21
80333 München (DE)

(54) **Physical quantity measuring apparatus and physical quantity measuring method**

(57) A physical quantity measuring apparatus (100) includes: a signal input module (110) receiving an input signal having consecutive pulses; a low resolution clock signal generator (130) generating a low resolution clock signal; a high resolution clock signal generator (140) generating a high resolution clock signal; a gate time generator (122) outputting gate time signals at a predetermined interval; a low resolution clock signal synchronizer (132) generating a low resolution clock synchronization signal; a low resolution counter (152) counting the number of rising edges of the low resolution clock signal; a high resolution clock signal generation controller (142) outputting the high resolution clock signal as a gated clock signal; a high resolution clock signal synchronizer (144) generating a high resolution clock synchronization signal; and a high resolution counter (154) counting the number of rising edges of the gated clock signal.

FIG. 1

EP 2 677 325 A2

**Description**

BACKGROUND

Technical Field

The present disclosure relates to a pulse number counting technique in which an interval between consecutive pulses belonging to an input signal is counted using a clock signal to thereby measure a physical quantity such as the frequency or the pulse interval of the input signal.

Related Art

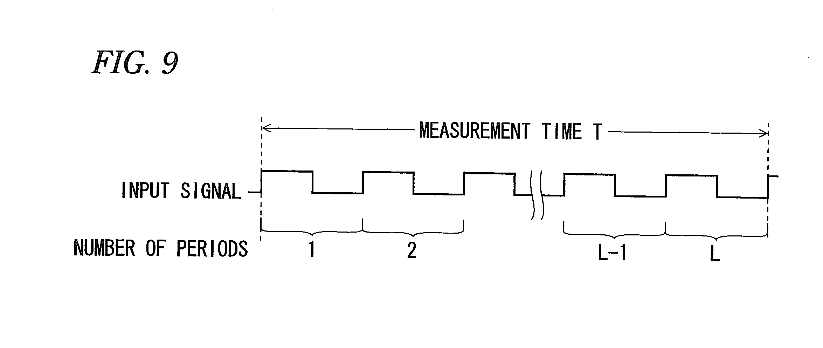

When the frequency of an input signal of consecutive pulses is measured, the number L of periods of the input signal occurring within a measurement time T can be counted and L/T [Hz] can be calculated to obtain the frequency, as shown in Fig. 9.

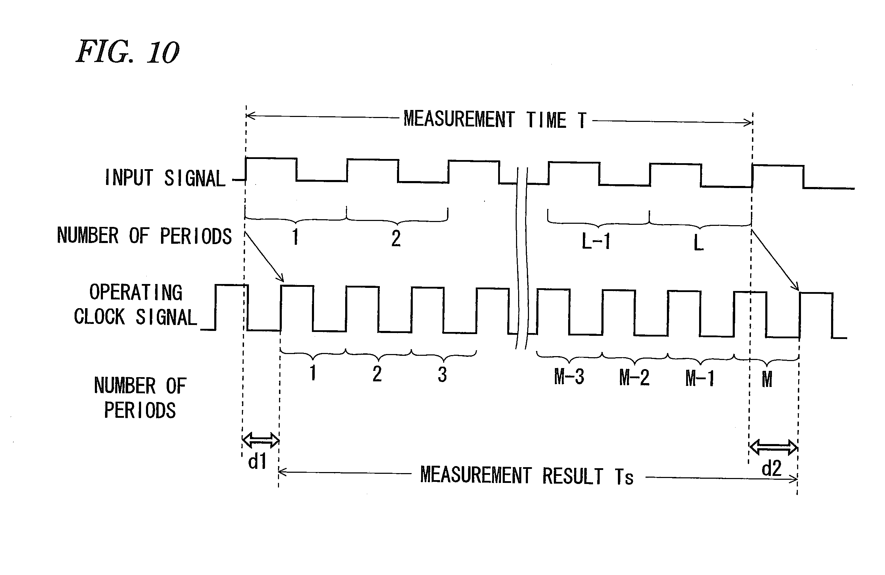

In real measurement using a digital measuring instrument operating in accordance with a predetermined clock, an input signal is sampled using the operating clock signal within the measurement time T so as to count the number L of periods of the input signal and the number M of periods of the operating clock signal, as shown in Fig. 10. Since the period $\tau$ of the operating clock signal is known and the measurement time T is expressed by $T=M\times\tau$, the frequency $\underline{f}$ of the input signal can be calculated in accordance with an expression $f=L/(M\times\tau)$.

However, since the input signal generally fluctuates out of sync with the operating clock signal, an error occurs between the measurement time T corresponding to the number L of periods of the input signal and a measurement result Ts. Specifically, a time d1 between an initial rising edge of the input signal and detection using the operating clock signal is not included in the measurement result Ts and a time d2 between the termination of the L-th period of the input signal and the termination of the measurement result Ts is measured redundantly. In this specification, the rising edge is set as an edge to be detected. However, a trailing edge may be set as the edge to be detected alternatively (*see e.g.,* JP-A-2004-198393).

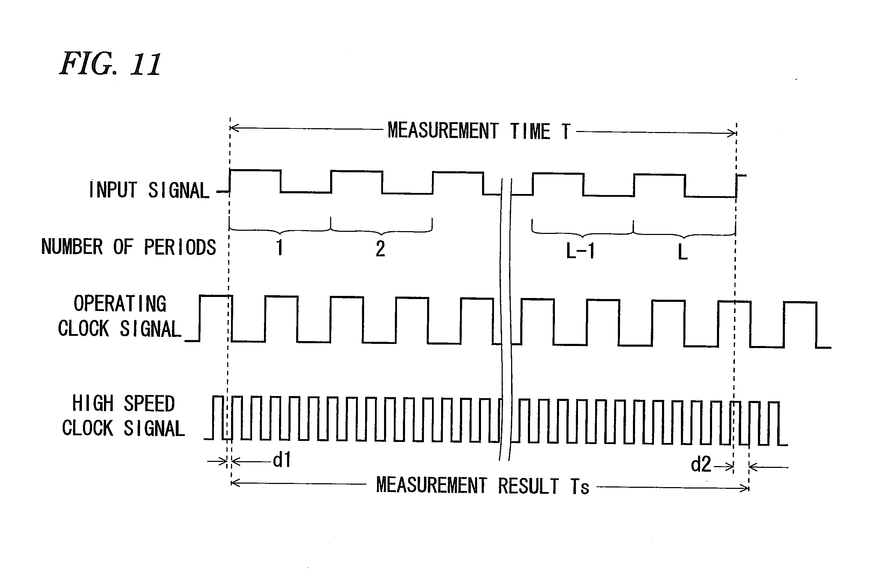

In order to measure the frequency accurately, it is necessary to reduce this error. To this end, as shown in Fig. 11, the input signal is sampled using a higher than the operating clock signal so that the error contained in the measurement result Ts can be reduced.

However, when the high speed clock signal is used for measuring the measurement time T, the number of bits of a counter for counting the number of periods of the high speed clock signal increases to thereby cause the increase of the scale of the circuit. When a measurement operation is performed with the high speed clock signal, power consumption increases. In some measuring instrument such as a two-wire transmitter, there may be a limitation in the supply of electric power. It is therefore preferable that power consumption is lower.

In order to perform accurate measurement while suppressing power consumption, JP-A-2004-198393 discloses that times d1 and d2 which are fractional times shorter than a period of an operating clock signal are expanded by use of a time width expansion circuit and the expanded fractional times are counted using the operating clock signal.

However, when the time width expansion circuit is mounted in a measuring instrument, the cost of the measuring instrument increases and another factor for a measurement error is added. In addition, since a time width is expanded and counted using the operating clock signal, there is another problem that it takes time to perform measurement.

SUMMARY OF THE INVENTION

An object of the invention is to improve the accuracy of physical quantity measurement without increasing power consumption when an input signal having consecutive pulses is counted using a clock signal.

According to one or more aspects of the present invention, there is provided a physical quantity measuring apparatus (100). The apparatus comprises: a signal input module (110) configured to receive an input signal having consecutive pulses; a low resolution clock signal generator (130) configured to generate a low resolution clock signal; a high resolution clock signal generator (140) configured to generate a high resolution clock signal, wherein a clock speed of the high resolution clock signal is higher than that of the low resolution clock signal; a gate time generator (122) configured to output gate time signals at a predetermined interval, wherein the gate time signals comprises a first gate time signal and a second gate time signal next to the first gate time signal; a low resolution clock signal synchronizer (132) configured to generate a low resolution clock synchronization signal from the input signal by synchronizing the input signal with the low resolution clock signal; a low resolution counter (152) configured to count the number of rising edges of the low resolution clock signal, wherein the low resolution counter (152) starts counting the number of the rising edges of the low resolution clock signal when detecting a rising edge of the low resolution clock synchronization signal using the low resolution clock signal after detecting the first gate time signal, and the low resolution counter (152) stops counting the number of the rising edges of the low resolution clock signal when detecting a rising edge of the low resolution clock synchronization signal using the low resolution clock signal after detecting the second gate time signal output next to the first gate time signal; a high resolution clock signal generation controller (142) configured to output the high resolution clock signal as a gated clock signal when detecting the first gate time signal using the low resolution clock signal; a high resolution clock signal synchronizer (144) configured to generate a high resolution clock synchronization signal from the input signal by synchronizing the input signal with the gated clock signal; and a high resolution counter (154) configured to count the number of rising edges of the gated clock signal, wherein the high resolution counter (154) starts counting the number of the rising edges of the gated clock signal when detecting a rising edge of the high resolution clock synchronization signal, and the high resolution counter (154) stops counting the number of the rising edges of the gated clock when the low resolution counter (152) starts counting the number of the rising edges of the low resolution clock signal.

According to one or more aspects of the present invention, there is provided a physical quantity measuring method for measuring a physical quantity of an input signal having consecutive pulses. The method comprises: (a) generating a low resolution clock signal; (b) generating a high resolution clock signal, wherein a clock speed of the high resolution clock signal is higher than that of the low resolution clock signal; (c) outputting gate time signals at a predetermined interval, wherein the gate time signals comprises a first gate time signal and a second gate time signal next to the first gate time signal; (d) generating a low resolution clock synchronization signal from the input signal by synchronizing the input signal with the first resolution clock signal; (e) counting the number of rising edges of the low resolution clock signal, the step(e) comprising: starting counting the number of the rising edges of the low resolution clock signal when detecting a rising edge of the low resolution clock synchronization signal using the low resolution clock signal after detecting the first gate time signal, and stopping counting the number of the rising edges of the low resolution clock signal when detecting a rising edge of the low resolution clock synchronization signal using the low resolution clock signal after detecting the second gate time signal output next to the first gate time signal; (f) outputting the high resolution clock signal as a gated clock signal when detecting the first gate time signal using the low resolution clock signal; (g) generating a high resolution clock synchronization signal from the input signal by synchronizing the input signal with the gated clock signal; and (h) counting the number of rising edges of the gated clock signal, the step (h) comprising: starting counting the number of the rising edges of the gated clock signal when detecting a rising edge of the high resolution clock synchronization signal; and stopping counting the number of the rising edges of the gated clock when the step (e) starts counting the number of the rising edges of the low resolution clock signal.

BRIEF DESCRIPTION OF DRAWINGS

Fig. 1 is a block diagram showing a configuration of a frequency measuring apparatus according to an embodiment of the invention;
Fig. 2 is a timing chart for explaining the relation between a gate time and a measurement time;
Fig. 3 is a timing chart showing a state in which an input signal is synchronized with a low resolution clock signal so as to generate a low resolution clock synchronization signal;
Fig. 4 is a timing chart for explaining generation of a gated clock signal and generation of a high resolution clock synchronization signal;
Fig. 5 is a flow chart for explaining a high resolution count operation according to the embodiment;
Fig. 6 is a flow chart for explaining a low resolution count operation and an input signal pulse number count operation according to the embodiment;
Fig. 7 is a timing chart showing an example of a count operation of the frequency measuring apparatus according to the embodiment;
Fig. 8 is a block diagram showing another configuration of the frequency measuring apparatus according to the embodiment;
Fig. 9 is a diagram for explaining the case where the frequency of an input signal of consecutive pulses is measured;
Fig. 10 is a diagram for explaining the case where a sampling operation is performed using an operating clock signal; and
Fig. 11 is a diagram for explaining the case where the sampling operation is performed using a high speed clock signal.

DETAILED DESCRIPTION

An embodiment of the invention will be described with reference to the drawings. The embodiment will be described in the case where the invention is applied to a frequency measuring apparatus. However, the invention is not limited to the frequency measuring apparatus but may be applied to any general physical quantity measuring apparatus having a configuration in which a pulse interval between consecutive pulses belonging to an input signal is counted using an operating clock signal. Such a physical quantity measuring apparatus includes a pulse number count device, a pulse interval measuring device, etc.

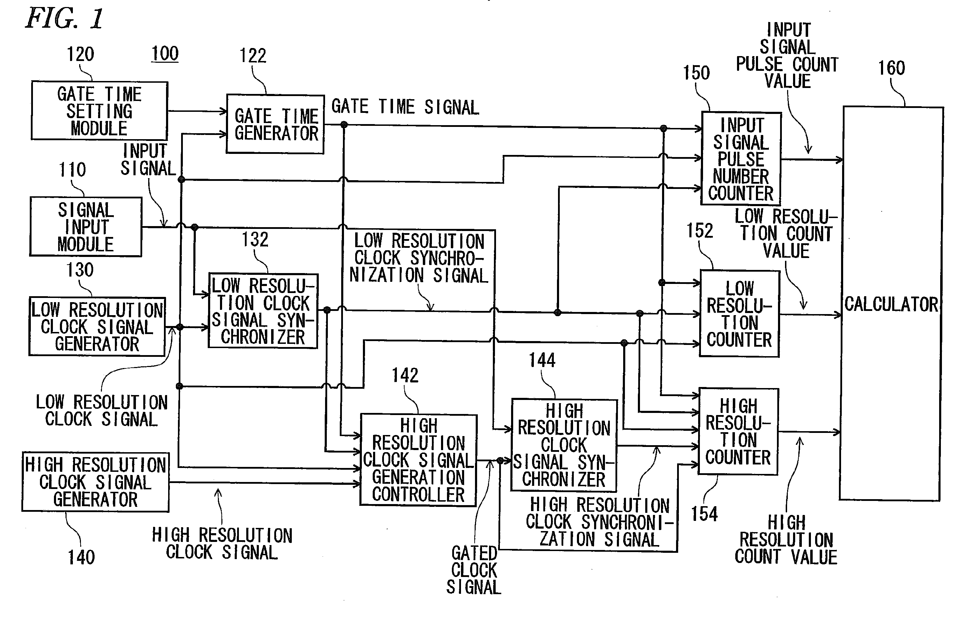

Fig. 1 is a block diagram showing a configuration of the frequency measuring apparatus according to the embodiment. As shown in Fig. 1, the frequency measuring apparatus 100 includes a signal input module 110, a gate time setting module 120, a gate time generator 122, a low resolution clock signal generator 130, a low resolution clock signal synchronizer 132, a high resolution clock signal generator 140, a high resolution clock signal generation controller 142, a high resolution clock signal synchronizer 144, an input signal pulse number counter 150, a low resolution counter 152, a high resolution counter 154, and an calculator 160.

The signal input module 110 accepts consecutive pulses whose frequency is to be measured. The consecutive pulses are generated, for example, in a sensor portion of a vibration pressure sensor, etc. The accepted signal is inputted as an input signal to the low resolution clock signal synchronizer 132 and the high resolution clock signal synchronizer 144.

The low resolution clock signal generator 130 generates a low resolution clock signal used as an operating clock signal. The low resolution clock signal is inputted to the gate time generator 122, the low resolution clock signal synchronizer 132, the high resolution clock signal generation controller 142, the input signal pulse number counter 150, the low resolution counter 152, and the high resolution counter 154.

The high resolution clock signal generator 140 generates a high resolution clock signal higher in resolution than the low resolution clock signal. The high resolution clock signal is inputted to the high resolution clock signal generation controller 142.

Incidentally, the speed of the high resolution clock signal is an integral multiple of the speed of the low resolution clock signal. Assume that the two clocks are synchronized with each other so that rising edge timing of the low resolution clock signal coincides with rising edge timing of the high resolution clock signal. In addition, assume that the low resolution clock signal and the high resolution clock signal have known frequencies and are always generated during measurement.

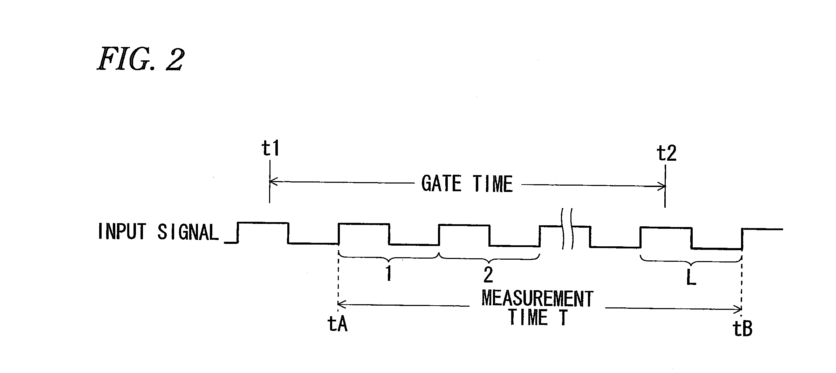

The gate time setting module 120 accepts setting of a gate time as a reference of a measurement time T and outputs the accepted setting of the gate time to the gate time generator 122. The gate time is a time which is a reference of the measurement time T and which can be set desirably by a user. When the gate time is a duration from t1 to t2 as shown in Fig. 2, a time between an initial rising edge timing tA of an input signal after t1 and an initial rising edge timing tB of the input signal after t2 is the measurement time T.

The gate time generator 122 generates a gate time signal at an interval of the set gate time in sync with the low resolution clock signal. In order to perform measurement continuously, the gate time signal is generated repetitively in each gate time. The gate time signal is inputted to the high resolution clock signal generation controller 142, the input signal pulse number counter 150, the low resolution counter 152 and the high resolution counter 154.

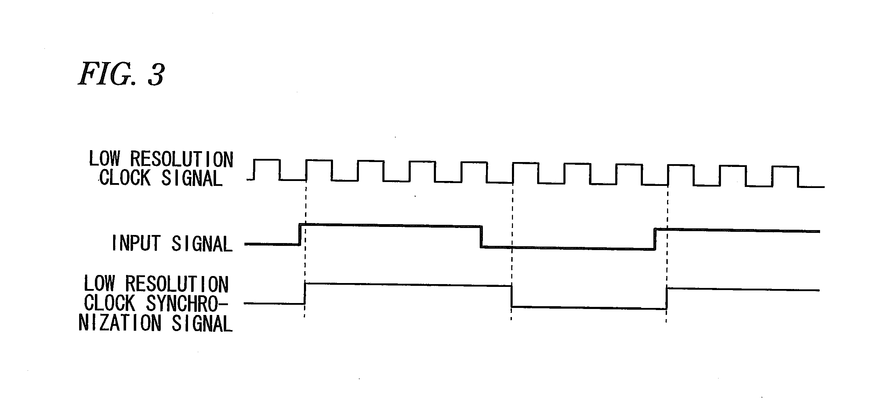

As shown in Fig. 3, the low resolution clock signal synchronizer 132 synchronizes an input signal in accordance with a low resolution clock signal so as to generate a low resolution clock synchronization signal. The low resolution clock synchronization signal is inputted to the high resolution clock signal generation controller 142, the input signal pulse number counter 150, the low resolution counter 152, and the high resolution counter 154.

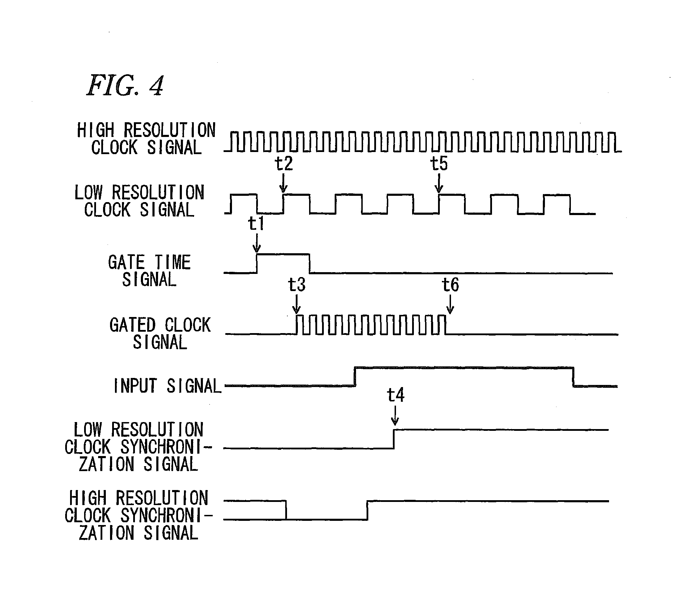

As shown in Fig. 4, when a gate time signal (t1) is detected in accordance with a low resolution clock signal (t2), the high resolution clock signal generation controller 142 outputs a high resolution clock signal as a gated clock signal (t3). The gated clock signal is inputted to the high resolution clock signal synchronizer 144 and the high resolution counter 154. When a rising edge (t4) of a low resolution clock synchronization signal is detected in accordance with the low resolution clock signal after the output of the gated clock signal (t5), the output of the gated clock signal is suspended (t6).

As a result, the gated clock signal which is a high resolution clock signal is outputted to a subsequent stage only when the gate time signal is detected. Therefore, the time in which operation is performed in accordance with the high resolution clock signal can be reduced so that accurate measurement using the high resolution clock signal can be made and the increase of power consumption can be avoided.

The high resolution clock signal synchronizer 144 synchronizes the input signal with the gated clock signal so as to generate a high resolution clock synchronization signal. Therefore, the high resolution clock synchronization signal is synchronized with the input signal only in the period in which the gated clock signal is outputted (see t3 to t6 in Fig. 4. Before t3, a previous gated clock signal synchronization state is kept). The high resolution clock synchronization signal is inputted to the high resolution counter 154.

The input signal pulse number counter 150 counts the number of rising edges of the low resolution clock synchronization signal between the assertion of the gate time signal and the assertion of the next gate time signal in sync with the low resolution clock signal. The count number of the input signal pulse number counter 150 corresponds to the number L of periods of the input signal occurring within the measurement time T corresponding to the gate time shown in Fig. 2, and is inputted as an input signal pulse count value to the calculator 160.

The low resolution counter 152 counts the number of rising edges of the low resolution clock signal between an initial rising edge of the low resolution clock synchronization signal after the assertion of the gate time signal and an initial rising edge of the low resolution clock synchronization signal after the assertion of the next gate time signal, in sync with the low resolution clock signal. The count value of the low resolution counter 152 corresponds to the number (M in Fig. 10) of clock ticks of the low resolution clock signal occurring within the measurement time T corresponding to the gate time and is inputted as a low resolution count value to the calculator 160.

The high resolution counter 154 counts the number of rising edges of the gated clock signal until an initial rising edge of the low resolution clock synchronization signal is detected in accordance with the low resolution clock signal after an initial rising edge of the high resolution clock synchronization signal after the assertion of the gate time signal is detected in accordance with the gated clock signal. The count value of the high resolution counter 154 approximates the fractional time d1 in Fig. 10 and is inputted as a high resolution count value to the calculator 160. Incidentally, a high resolution count value acquired in the next gate time approximates the fractional time d2 in Fig. 10.

The calculator 160 calculates the measurement time T based on the input signal pulse count value, the low resolution count value and the high resolution count value and calculates the frequency of the input signal based on the measurement time T. A specific calculation method will be described later.

Next, a pulse number count operation of the frequency measuring apparatus 100 according to the embodiment will be described. Assume that measurement determined by a gate time is repeated a plurality of times and the number of times of measurement is designated by N. In addition, assume that an input signal pulse count value, a low resolution count value, and a high resolution count value in the number N of times of measurement are expressed as input signal pulse count value (N), low resolution count value (N), and high resolution count value (N), respectively.

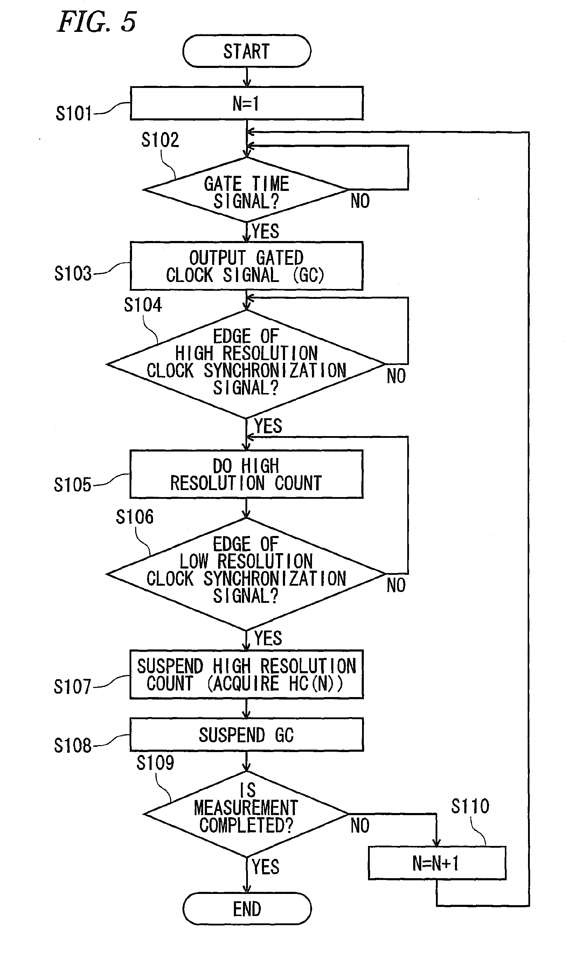

Firstly, a high resolution count operation will be described with reference to the flow chart of Fig. 5. The number N of times of measurement is initialized to 1 (S101). When a gate time signal is detected (Yes in S102), the high resolution clock signal generation controller 142 starts an output of a gated clock signal (S103).

When an input signal is synchronized with the gated clock signal by the high resolution clock signal synchronizer 144 and a rising edge of a high resolution clock synchronization signal is detected (Yes in S104), the high resolution counter 154 counts the number of rising edges of the gated clock signal (S105).

The count of the gated clock signal is performed until a rising edge of a low resolution clock synchronization signal is detected in accordance with a low resolution clock signal. When the rising edge of the low resolution clock synchronization signal is detected in accordance with the low resolution clock signal (Yes in S106), the high resolution counter 154 suspends the count (S107). In this manner, a high resolution count value (1) in the number of times of measurement N = 1 is acquired.

In addition, the high resolution clock signal generation controller 142 suspends the output of the gated clock signal after the suspension of the count of the high resolution counter 154 (S108). In this manner, measurement operation based on the gated clock signal is not performed until a next gate time signal. Accordingly, power consumption can be prevented from increasing due to the use of the high resolution clock signal.

Then, N is set as N = N + 1 (S110). High resolution count values (N) on and after the second time are acquired repeatedly until the measurement is completed (S109).

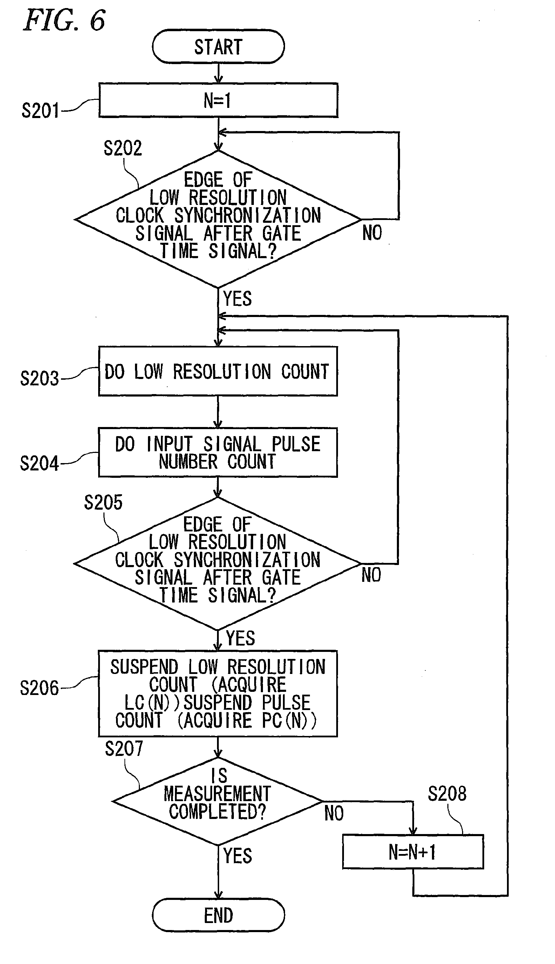

Next, a low resolution count operation and an input signal pulse number count operation will be described with reference to the flow chart of Fig. 6. The number N of times of measurement is initialized to 1 (S201). When an initial rising edge of a low resolution clock synchronization signal is detected in accordance with a low resolution clock signal after detection of a gate time signal (Yes in S202), the low resolution counter 152 counts the number of rising edges of the low resolution clock signal (S203) and the input signal pulse number counter 150 counts the number of rising edges of the low resolution clock synchronization signal (S204).

The two counts are performed until an initial rising edge of a low resolution clock synchronization signal is detected in accordance with the low resolution clock signal after detection of a next gate time signal. When the initial rising edge of the low resolution clock synchronization signal is detected in accordance with the low resolution clock signal after detection of the next gate time signal (Yes in S205), the two counts are suspended. In this manner, a low resolution count value (1) and an input signal pulse count value (1) in the number of times of measurement N = 1 are acquired (S206).

Then, N is set as N = N + 1 (S208). Low resolution count values (N) and input signal pulse count values (N) on and after the second time are acquired repeatedly until the measurement is completed (S208). The two counts are performed continuously respectively. Accordingly, each acquired count value (N) should be saved immediately or a plurality of counters should be used for each count.

The calculator 160 calculates a measurement time T based on the high resolution count values and the low resolution count values acquired in the aforementioned procedures. The measurement time T(N) relevant to N-th measurement can be calculated based on the following expression on the assumption that the period of the low resolution clock signal is regarded as $\tau L$ and the period of the high resolution clock signal is regarded as $\tau H$. Incidentally, the following expression (1) corresponds to measurement time T = measurement result Ts + d1 - d2 in Fig. 10.

$$\text{Measurement Time } T(N) = \text{Low Resolution Count Value } (N) \times \tau L + \text{High Resolution Count Value } (N) \times \tau H - \text{High Resolution Count Value } (N+1) \times \tau H \ldots (1)$$

That is, the N-th high resolution count value (N) and the (N+1)-th high resolution count value (N+1) are used for calculation of the measurement time T (N).

In addition, the calculator calculates a frequency f(N) of the input signal in accordance with the following expression (2) based on the calculated measurement time T(N) and the input signal pulse count value (N) acquired in the aforementioned procedure.

$$\text{Frequency } f(N) = \text{Input Signal Pulse Count Value } (N) \: / \: \text{Measurement Time } T(N) \ldots (2)$$

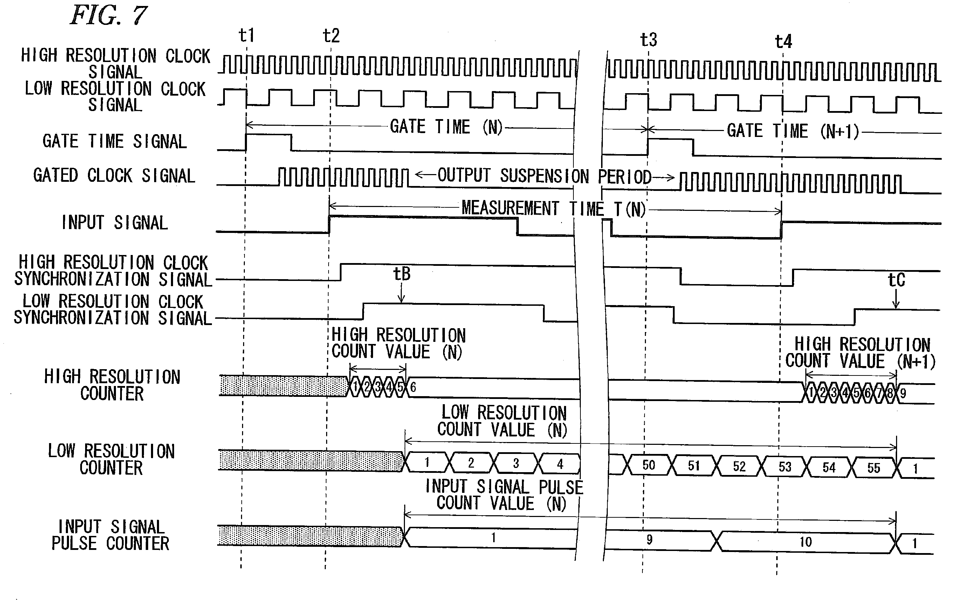

Fig. 7 is a timing chart showing an example of a count operation of the frequency measuring apparatus 100 performed in the aforementioned procedure. In the example of Fig. 7, a gate time signal occurs at timing t1 and is detected in accordance with a low resolution clock signal so that an output of a gated clock signal is started.

A rising edge of an input signal occurs at timing t2 and a high resolution count for N-th measurement is started in sync with the gated clock signal. Then, when a rising edge of a low resolution clock synchronization signal is detected at timing tB in sync with the low resolution clock signal, the high resolution count is suspended and the output of the gated clock signal is suspended. At the same time, a low resolution count and an input signal pulse count for the N-th measurement are started.

A next gate time signal occurs at timing t3. After that, a rising edge of the input signal occurs at timing t4. When a rising edge of the low resolution clock synchronization signal is detected at timing tC, the low resolution count and the input signal pulse count for the N-th measurement are suspended and count for a (N+1)-th measurement is started.

In addition, the output of the gated clock signal is resumed in response to the next gate time signal at the timing t3. Then, due to the rising edge of the input signal at the timing t4, a high resolution count for the (N+1)-th measurement is started and the high resolution count for the (N+1)-th measurement is suspended at the timing tC.

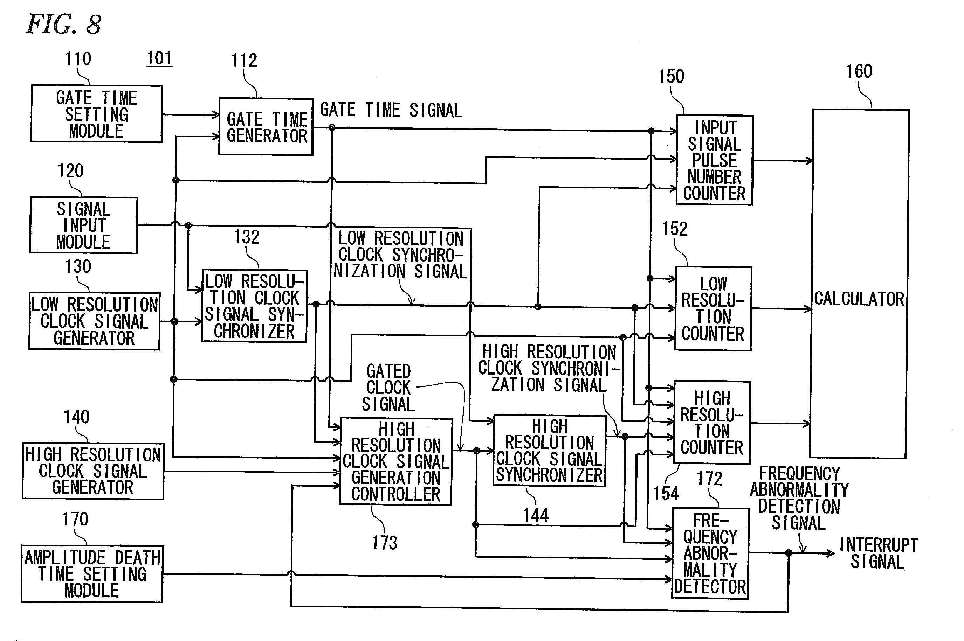

Next, another configuration of a frequency measuring apparatus 101 will be described with reference to Fig. 8. For example, assume that a sensor signal of a vibration pressure sensor is used as an input signal. When there occurs abnormality such as amplitude death in this case, a gated clock signal may be outputted as it is after a gate time signal while a low resolution clock synchronization signal is not detected. Thus, power consumption may increase.

Therefore, the frequency measuring apparatus 101 shown in Fig. 8 includes an additional configuration in which a gated clock signal is suspended upon detection of frequency abnormality in order to prevent the increase of power consumption. Specifically, an amplitude death time setting module 170 and a frequency abnormality detector 172 are added to the aforementioned frequency measuring apparatus 100. In addition, a high resolution clock signal generation controller 173 includes not only the function of the aforementioned high resolution clock signal generation controller 142 but also an additional function of suspending an output of a gated clock signal upon reception of a frequency abnormality detection signal.

The amplitude death time setting module 170 accepts setting of a count value of a gated clock signal which can be determined as frequency abnormality. The gated clock signal is outputted until a rising edge of a low resolution clock synchronization signal after detection of a gate time signal. However, the rising edge is not detected when there occurs frequency abnormality. Therefore, the maximum number of clock ticks of the gated clock signal in a lower limit frequency of an input signal is estimated and set so that the frequency abnormality can be determined.

The frequency abnormality detector 172 is provided with a counter which counts the number of clock ticks of the gated clock signal after detection of the gate time signal. When this count value exceeds an amplitude death time set value before detection of a rising edge of a high resolution clock synchronization signal (or a rising edge of a low resolution clock synchronization signal), the frequency abnormality detector 172 determines that there occurs frequency abnormality, and outputs a frequency abnormality detection signal.

The frequency abnormality detection signal is inputted to the high resolution clock signal generation controller 173 so that the output of the gated clock signal is suspended. In this manner, the increase of power consumption can be prevented. In addition, it is desirable that a not-shown CPU is informed of the frequency abnormality detection signal as an interrupt signal. Incidentally, the function of the frequency abnormality detector 172 may be built in the high resolution clock signal generation controller 173.

**Claims**

1. A physical quantity measuring apparatus (100) comprising:

a signal input module (110) configured to receive an input signal having consecutive pulses;
a low resolution clock signal generator (130) configured to generate a low resolution clock signal;
a high resolution clock signal generator (140) configured to generate a high resolution clock signal, wherein a clock speed of the high resolution clock signal is higher than that of the low resolution clock signal;
a gate time generator (122) configured to output gate time signals at a predetermined interval, wherein the gate time signals comprises a first gate time signal and a second gate time signal next to the first gate time signal;
a low resolution clock signal synchronizer (132) configured to generate a low resolution clock synchronization signal from the input signal by synchronizing the input signal with the low resolution clock signal;
a low resolution counter (152) configured to count the number of rising edges of the low resolution clock signal, wherein the low resolution counter (152) starts counting the number of the rising edges of the low resolution clock signal when detecting a rising edge of the low resolution clock synchronization signal using the low resolution clock signal after detecting the first gate time signal, and the low resolution counter (152) stops counting the number of the rising edges of the low resolution clock signal when detecting a rising edge of the low resolution clock synchronization signal using the low resolution clock signal after detecting the second gate time signal output next to the first gate time signal;
a high resolution clock signal generation controller (142) configured to output the high resolution clock signal as a gated clock signal when detecting the first gate time signal using the low resolution clock signal;
a high resolution clock signal synchronizer (144) configured to generate a high resolution clock synchronization signal from the input signal by synchronizing the input signal with the gated clock signal; and
a high resolution counter (154) configured to count the number of rising edges of the gated clock signal, wherein the high resolution counter (154) starts counting the number of the rising edges of the gated clock signal when detecting a rising edge of the high resolution clock synchronization signal, and the high resolution counter (154) stops counting the number of the rising edges of the gated clock when the low resolution counter (152) starts counting the number of the rising edges of the low resolution clock signal.

2. The apparatus of claim **1,** further comprising:

an calculator (160) configured to calculate measurement time (T) of the input signal, based on following:

i) the number of rising edges of the low resolution clock signal, which the low resolution counter (152) starts counting after detecting the first gate time signal;
ii) the number of rising edges of the gated clock signal, which is counted after detection of the first gate time signal;
iii) the number of rising edges of the gated clock signal, which is counted after detection of the second gate time signal;
iv) a period of the high resolution clock signal; and
v) a period of the low resolution clock signal.

3. The apparatus of claim **2,** further comprising:

an input signal pulse number counter (150) configured to count the number of rising edges of the input signal in the measurement time of the input signal,
wherein the calculator (160) is further configured to calculate a frequency of the input signal, based on the measurement time of the input signal and the number of the rising edges of the input signal.

4. The apparatus of claim **1,** wherein the high resolution clock signal generation controller (142) is further configured to stop outputting the gated clock signal, when the number of the rising edges of the gated clock signal, which are successively output, exceeds a threshold value.

5. A physical quantity measuring method for measuring a physical quantity of an input signal having consecutive pulses, the method comprising:

(a) generating a low resolution clock signal;
(b) generating a high resolution clock signal, wherein a clock speed of the high resolution clock signal is higher than that of the low resolution clock signal;

(c) outputting gate time signals at a predetermined interval, wherein the gate time signals comprises a first gate time signal and a second gate time signal next to the first gate time signal;

(d) generating a low resolution clock synchronization signal from the input signal by synchronizing the input signal with the first resolution clock signal;

(e) counting the number of rising edges of the low resolution clock signal, the step(e) comprising:

starting counting the number of the rising edges of the low resolution clock signal when detecting a rising edge of the low resolution clock synchronization signal using the low resolution clock signal after detecting the first gate time signal, and

stopping counting the number of the rising edges of the low resolution clock signal when detecting a rising edge of the low resolution clock synchronization signal using the low resolution clock signal after detecting the second gate time signal output next to the first gate time signal;

(f) outputting the high resolution clock signal as a gated clock signal when detecting the first gate time signal using the low resolution clock signal;

(g) generating a high resolution clock synchronization signal from the input signal by synchronizing the input signal with the gated clock signal; and

(h) counting the number of rising edges of the gated clock signal, the step (h) comprising:

starting counting the number of the rising edges of the gated clock signal when detecting a rising edge of the high resolution clock synchronization signal; and

stopping counting the number of the rising edges of the gated clock when the step (e) starts counting the number of the rising edges of the low resolution clock signal.

*FIG. 1*

*FIG. 2*

EP 2 677 325 A2

## FIG. 3

EP 2 677 325 A2

## FIG. 4

HIGH RESOLUTION
CLOCK SIGNAL

LOW RESOLUTION
CLOCK SIGNAL

t2    t5

t1

GATE TIME
SIGNAL

t3    t6

GATED CLOCK
SIGNAL

INPUT SIGNAL

t4

LOW RESOLUTION
CLOCK SYNCHRONI-
ZATION SIGNAL

HIGH RESOLUTION
CLOCK SYNCHRONI-
ZATION SIGNAL

*FIG. 5*

```
                    ┌──────────────┐
                    │    START     │
                    └──────┬───────┘
                           ↓
S101 ─────┐    ┌──────────────────────┐
          └────│         N=1          │
               └──────────┬───────────┘
                          ↓ ←───────────────────────────┐
   S102                   ↓ ←──────────────┐            │
      ╲          ╱────────────────╲        │            │
       ╲────────╱   GATE TIME      ╲  NO   │            │
                ╲   SIGNAL?         ╱───────┘            │
                 ╲────────┬────────╱                     │
                          ↓YES                           │
S103 ─────┐    ┌──────────────────────┐                 │
          └────│  OUTPUT GATED        │                 │
               │  CLOCK SIGNAL (GC)   │                 │
               └──────────┬───────────┘                 │
   S104                   ↓ ←──────────────┐            │
      ╲          ╱────────────────╲        │            │
       ╲────────╱   EDGE OF        ╲       │            │
                │  HIGH RESOLUTION  │ NO   │            │
                │ CLOCK SYNCHRONIZATION────┘            │
                ╲   SIGNAL?         ╱                    │
                 ╲────────┬────────╱                     │
                          ↓YES                           │
S105 ─────┐    ┌──────────────────────┐ ←──────┐        │
          └────│   DO HIGH            │        │        │
               │ RESOLUTION COUNT     │        │        │
               └──────────┬───────────┘        │        │
   S106                   ↓                     │        │
      ╲          ╱────────────────╲            │        │
       ╲────────╱   EDGE OF        ╲           │        │
                │  LOW RESOLUTION   │ NO        │        │
                │ CLOCK SYNCHRONIZATION─────────┘        │
                ╲   SIGNAL?         ╱                    │
                 ╲────────┬────────╱                     │
                          ↓YES                           │
S107 ─────┐    ┌──────────────────────┐                 │
          └────│ SUSPEND HIGH RESOLUTION│               │
               │ COUNT (ACQUIRE HC(N)) │                │
               └──────────┬───────────┘                 │
S108 ─────┐    ┌──────────────────────┐                 │
          └────│    SUSPEND GC        │                 │
               └──────────┬───────────┘                 │
   S109                   ↓                              │
      ╲          ╱────────────────╲    S110             │
       ╲────────╱     IS           ╲   ┌──────────┐     │
                │  MEASUREMENT      │NO │  N=N+1   │─────┘
                ╲  COMPLETED?       ╱───└──────────┘
                 ╲────────┬────────╱
                          ↓YES
                    ┌──────────────┐
                    │     END      │
                    └──────────────┘
```

*FIG. 6*

```
                    ┌──────────────┐
                    │    START     │
                    └──────┬───────┘
                           │
S201 ─┌────────────────────────────────┐
      │             N=1                 │
      └────────────────┬───────────────┘
                       │            ◄────────────┐
S202                   ▼                          │
              EDGE OF                             │
         LOW RESOLUTION                           │
    CLOCK SYNCHRONIZATION            NO           │
      SIGNAL AFTER GATE ─────────────────────────┘
         TIME SIGNAL?
                       │ YES
                       ▼            ◄────────────────────┐
                       │      ◄──────────────┐           │
S203 ─┌────────────────────────────────┐    │           │
      │   DO LOW RESOLUTION COUNT       │    │           │
      └────────────────┬───────────────┘    │           │
                       ▼                     │           │
S204 ─┌────────────────────────────────┐    │           │
      │  DO INPUT SIGNAL PULSE          │    │           │
      │       NUMBER COUNT              │    │           │
      └────────────────┬───────────────┘    │           │
S205                   ▼                     │           │
              EDGE OF                        │           │
         LOW RESOLUTION                      │           │
    CLOCK SYNCHRONIZATION          NO        │           │
      SIGNAL AFTER GATE ───────────────────►─┘           │
         TIME SIGNAL?                                     │
                       │ YES                              │
S206 ─┌────────────────────────────────┐                 │
      │  SUSPEND LOW RESOLUTION         │                 │
      │      COUNT (ACQUIRE             │                 │
      │  LC(N)) SUSPEND PULSE           │                 │
      │  COUNT (ACQUIRE PC(N))          │                 │
      └────────────────┬───────────────┘                 │
S207                   ▼                                  │
                    IS                    NO      S208    │
              MEASUREMENT ──────────────────►┌──────────┐│
              COMPLETED?                      │  N=N+1   │┘
                       │ YES                  └──────────┘
                       ▼
                    ┌──────────────┐
                    │    END       │
                    └──────────────┘
```

*FIG. 7*

EP 2 677 325 A2

FIG. 8

*FIG. 9*

MEASUREMENT TIME T

INPUT SIGNAL

NUMBER OF PERIODS   1   2   L−1   L

*FIG. 10*

## FIG. 11

MEASUREMENT TIME T

INPUT SIGNAL

NUMBER OF PERIODS    1    2         L-1    L

OPERATING
CLOCK SIGNAL

HIGH SPEED
CLOCK SIGNAL

d1                                    d2

MEASUREMENT RESULT Ts

EP 2 677 325 A2

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- JP 2004198393 A